Europäisches Patentamt

European Patent Office

Office européen des brevets

(19)

(11) **EP 0 714 031 B1**

(12) **EUROPÄISCHE PATENTSCHRIFT**

(45) Veröffentlichungstag und Bekanntmachung des Hinweises auf die Patenterteilung:
**17.05.2000 Patentblatt 2000/20**

(51) Int Cl.[7]: **G01R 31/04**, G01R 27/20, G01J 5/48

(21) Anmeldenummer: **95117985.2**

(22) Anmeldetag: **15.11.1995**

(54) **Verfahren zur Kontaktdiagnose an Elektroanlagen**

Method for contact diagnosis for electrical installations

Méthode pour le diagnostic de l'état d'un contact pour des installations électriques

(84) Benannte Vertragsstaaten:
**AT CH DE LI NL SE**

(30) Priorität: **25.11.1994 DE 4442070**

(43) Veröffentlichungstag der Anmeldung:
**29.05.1996 Patentblatt 1996/22**

(73) Patentinhaber: **RIBE-HAW Elektrotechnik GmbH & Co. KG**
**01445 Radebeul (DE)**

(72) Erfinder:
• **Löbl, Helmut, Dr.-Ing.habil.**
**D-01187 Dresden (DE)**
• **Böhme, Helmut, Prof. Dr.-Ing.habil.**
**D-69226 Nussloch (DE)**
• **Grossmann, Steffen, Dr.-Ing.**
**D-01187 Dresden (DE)**
• **Rogler, Ralf-Dieter, Dipl.-Ing.**
**D-01139 Dresden (DE)**
• **Bergmann, Ralf, Dipl.-Ing.**
**D-01809 Meusegast (DE)**
• **Bürkner, Jens, Dipl.-Ing.**
**D-06237 Leuna (DE)**

(74) Vertreter: **Heyner, Klaus, Dr.-Ing.**
**Mittelweg 1h**
**01728 Bannewitz/Dresden (DE)**

(56) Entgegenhaltungen:
**US-A- 4 584 523**

• **THIRD INTERNATIONAL CONFERENCE ON POWER CABLES AND ACCESSORIES 10KV - 500KV (CONF. PUBL. NO.382), LONDON, UK, 23-25 NOV. 1993, ISBN 0-85296-592-3, 1993, LONDON, UK, IEE, UK, Seiten 130-134, DANG C ET AL 'Thermal performance modeling of power cable joints'**
• **ELEKTROTECHNISCHE ZEITSCHRIFT - ETZ, Bd. 114, Nr. 4, 1.Februar 1993 Seiten 264-266, 268 - 269, XP 000350027 BOEHME H ET AL 'MESSUNG DES VERBINDUNGSWIDERSTANDS'**
• **ELEKTRIE, Bd. 41, Nr. 5, 1987 BERLIN,DE, Seiten 179-183, BOEHME H. ET AL. 'Zur Theorie des Lanzeitverhaltens von Aluminium-Schraubverbindungen'**

## Beschreibung

Die Erfindung bezieht sich auf die Diagnose an Verbindungen der Elektroenergietechnik nach dem Oberbegriff des Anspruchs 1.

Elektrische Verbindungen bzw. Kontakte unterliegen, abhängig von der Belastung durch Strom und Umwelt, einer Alterung.

Der Widerstand elektrischer Verbindungen $R_V$ wird dabei abhängig von der Belastung durch den Strom und durch Umwelteinwirkungen (z.B. Umgebungstemperatur, Feuchtigkeit, Schadgasbelastung der Atmosphäre) über die Betriebszeit der Verbindungen größer.

Um den Zustand der Verbindungen einschätzen zu können bzw. um Ausfälle von Anlagen der Elektroenergieübertragung zu vermeiden, muß eine Verbindungsdiagnose bzw. Kontaktdiagnose durchgeführt werden. Der Elektroenergietransport zum Verbraucher kann bei der Diagnose oft nicht unterbrochen werden.

Für eine zuverlässige und langzeitstabile Elektroenergieversorgung ist es also zweckmäßig, den Zustand der Verbindungen während des normalen Betriebes der Elektroanlage zu diagnostizieren.

Die entscheidende physikalische Größe für die Festlegung eines oberen Grenzwertes zur Beurteilung einer Verbindung ist ein maximal zulässiger Verbindungswiderstand, der sich aus einer zulässigen Grenztemperatur ergibt. Die Temperatur der Verbindung wird durch die in ihr erzeugte Verlustleistung $P_V = I^2 R_V$ hervorgerufen.

In freigeschalteten elektrotechnischen Anlagen wird der Widerstand der Verbindung durch eine Strom-Spannungs-Messung direkt erfaßt. An den unter Spannung stehenden und vom Betriebsstrom durchflossenen sowie an schwer zugänglichen Verbindungen und Anschlüssen elektrotechnischer Betriebsmittel ist es dagegen nicht möglich, den Verbindungswiderstand direkt zu messen. Der Verbindungswiderstand kann in diesen Fällen indirekt über seine Wirkung, d.h. über die Temperatur der Verbindung, bestimmt werden.

Da sich der Zustand der Verbindung, ausgedrückt durch die Größe des Verbindungswiderstandes, über die Temperatur abbildet, wird zur Diagnose die Infrarotmeßtechnik (Infrarotkamera) eingesetzt.

Bisher wurde versucht, durch Vergleichsmessungen zwischen benachbarten Leitern oder durch Trendanalysen gefährliche Schwachstellen (Heißpunkte) in den Anlagen zu erkennen und zu bewerten. Diese Bewertung erfolgte bisher ausschließlich aus der Temperatur.

Die alleinige Bewertung der Temperatur der Verbindung durch einen Vergleich mit gegebenen Grenztemperaturen kann aber ohne Berücksichtigung weiterer Einflußgrößen mit großen Fehlern bei der Bestimmung der Restnutzungsdauer verbunden sein.

Die Temperatur ist außer von der Höhe des Kontaktwiderstandes noch wesentlich von der Strombelastung, vom Wind, der Sonnen- und Himmelsstrahlung und der Umgebungstemperatur abhängig. Diese Einflüsse werden bei bisherigen Diagnoseverfahren (Hermann, K., Walter, L. Wissenspeicher Infrarotmeßtechnik, Fachbuchverlag Leipzig 1990) weder mit der notwendigen Genauigkeit und ihrer zeitlichen Änderung erfaßt, noch wird ihre Wirkung auf das System berücksichtigt. Aussagen zur Restnutzungsdauer oder zu einer zeitlich definierten Erneuerung der untersuchten Verbindungen können bisher nicht gemacht werden.

Diese Tatsache führt dazu, daß trotz aufwendiger und teurer Meßtechnik die Diagnose ungenau ist. Verbindungen werden unter Umständen falsch diagnostiziert. Dies kann sowohl dazu führen, daß noch intakte Verbindungen ausgewechselt werden als auch, daß nicht erkannte Schwachstellen zu Havarien (Ausfall der Elektroenergieübertragung) führen.

Ist der Verbindungswiderstand bekannt, kann mit einem mathematischen Alterungsmodell nach Böhme, H.; Löbl, H.: "Zur Theorie des Langzeitverhaltens von Aluminium-Schraubverbindungen", Elektrie 41 (87) 5, S. 179/83 bzw. Bergmann, R.: "Zum Langzeitverhalten des Widerstandes elektrischer Stromschienenverbindungen", Dissertation 1995 TU Dresden der determinierte Verlauf der Widerstandszunahme berechnet werden. Die bis zum Erreichen des Grenzwertes verbleibende Zeit $\Delta t_R$ wird als Restnutzungsdauer bezeichnet.

Aufgabe der Erfindung ist es deshalb, im Rahmen der berührungslosen Diagnose an Verbindungen in Anlagen der Elektroenergietechnik den momentanen Verbindungswiderstand $R_V$ unter Berücksichtigung aller signifikanten, zeitlich veränderlichen, die Temperatur der Kontaktverbindung beeinflussenden Parameter, wie Belastungsstrom, Windgeschwindigkeit und Windrichtung, Umgebungstemperatur, Sonnen- und Himmelsstrahlung zu erfassen und zu bewerten.

Es soll also berührungslos der Widerstand einer Verbindung ermittelt werden, die unter einer hohen elektrischen Spannung steht und über die Elektroenergie übertragen wird.

Diese Aufgabe wird erfindungsgemäß durch die Merkmale des Hauptanspruchs gelöst, die Unteransprüche zeigen weitere vorteilhafte Ausgestaltungen der Erfindung.

Die Bestimmung des Verbindungswiderstandes über die Temperatur ist möglich, wenn die Wirkung der Parameter bekannt ist, die die Erwärmung der Verbindung beeinflussen. Neben dem Verbindungswiderstand und dem Belastungsstrom haben noch folgende dynamische Größen einen wesentlichen Einfluß auf die Temperatur:

- Windgeschwindigkeit und Windrichtung (in Freiluftanlagen),

- Sonnen- und Himmelsstrahlung (in Freiluftanlagen),

- Umgebungstemperatur,

Weitere das zu diagnostizierende Objekt beschreibende Größen sind:

- Geometrie der Verbindung und der angeschlossenen Leiter sowie deren Wärmespeicher- und Wärmeleitvermögen

- elektrisches Leitvermögen der angeschlossenen Leiter

- Absorptions- und Emissionsvermögen der Verbindung und der Leiter

- Ähnlichkeitsfunktionen des konvektiven Wärmeübergangs für Verbindung und Leiter

- temperaturabhängige Stoffwerte der Luft.

Alle genannten Größen gehen als Parameter in das Wärmenetzmodell zur Berechnung der Temperaturverteilung und des Temperaturverlaufs sowie zur Bestimmung des Verbindungswiderstandes $R_V$ ein.

Durch Experimente und Modellrechnungen (z.B. mittels der Wärmenetzmethode) wird ein thermisches Modell der zu diagnostizierenden Verbindungen erstellt. Mit diesem Modell ist es möglich, aus der gemessenen Temperatur der Verbindung und unter Berücksichtigung der gleichzeitig erfaßten Umgebungsbedingungen den Momentanwert des Widerstands der Verbindung zu berechnen. Die Temperatur der Verbindung und des angeschlossenen Leiters als wesentliche Bewertungsgröße kann während des Betriebs der Anlage berührungslos mit z.B. der Infrarot-Thermografie gemessen werden.

Der erfindungsgemäße Verfahrensablauf zur Ermittlung des Verbindungswiderstandes Ru kann wie folgt beschrieben werden.

Für die zu diagnostizierende Verbindung wird das dynamische Wärmenetz der Wärmenetzbibliothek entnommen oder erforderlichenfalls neu entwickelt.

Über eine ausreichende Zeitspanne wird an der Verbindung die Temperaturverteilung und der Temperaturverlauf mit z.B. einer Infrarotkamera gemessen und aufgezeichnet. Zeitgleich werden alle wesentlichen dynamischen Einflußgrößen erfaßt und ebenfalls aufgezeichnet. Diese Größen sind in der Regel: Belastungsstrom, Windgeschwindigkeit und -richtung, Leistung der Sonnen-und Himmelsstrahlung und Umgebungstemperatur. Sie werden als zeitabhängige Daten zur Berechnung der Temperatur in das die jeweilig zu untersuchende Verbindung abbildende Wärmenetz eingegeben. Daraus werden sowohl Temperaturverlauf als auch Temperaturverteilung für die zu diagnostizierende Verbindung mit dem angeschlossenen Leiter berechnet. Durch Vergleich der gemessenen und berechneten Temperaturen können unter Veränderung des zu diagnostizierenden Verbindungswiderstandes diese Temperaturen einander angepaßt werden. Stimmen Verlauf und Verteilung überein, ist der gesuchte Widerstand Ru ermittelt.

Mit einem dynamischen Wärmenetzmodell ist also aus der gemessenen Temperatur und den sie beeinflussenden Parametern der Verbindungswiderstand zu berechnen. Ist der Widerstand bekannt, wird abhängig von der zu erwartenden Strombelastung die Restnutzungsdauer $\Delta t_R$ mit dem Lebensdauermodell für elektrische Verbindungen bestimmt.

Dieses Modell erfaßt die Alterungsgeschwindigkeit $\dot{R}_V$ abhängig vom Verbindungswiderstand $R_V$ und dem Widerstand der Verbindung bei idealem Kontakt $R_I$, der Temperatur an der Engestelle $T_E$ und dem dort auftretenden Fremdschichtwachstum ($\approx t^{-m}$). Die Parameter m, B und d der Alterungsgleichung sind aus Langzeitversuchen an vergleichbaren Verbindungen mit ähnlicher Belastung zu ermitteln:

$$\dot{R}_V = \frac{R_V - R_I}{\left(\frac{t}{t_o}\right)^m \cdot t_o} \, d \, e^{-\left(\frac{B}{R \, T_E} + \frac{1}{2}\right)}$$

wobei R die Gaskonstante und $t_o$ die Bezugszeit ist, die zweckmäßig mit $t_o$ = 1 Stunde angenommen wird.

Mit Hilfe des Alterungsmodells ist es möglich, die Lebensdauer von neu montierten bzw. die Restnutzungsdauer von bereits im Betrieb befindlichen elektrischen Verbindungen abhängig von der Belastung (z.B. Strom, Umgebungstemperatur) und des Verbindungswiderstandes $R_V$ zu ermitteln.

Die Bewertung des ermittelten Verbindungswiderstandes kann durch den Vergleich mit vorgegebenen Grenzwerten erfolgen. Abhängig von der Differenz zwischen dem gemessenen Verbindungswiderstand und einem Grenzwert muß entschieden werden, ob die Verbindung bis zur nächsten Überprüfung weiter betrieben werden darf oder ob eine sofortige Erneuerung notwendig ist.

Als wesentliche Vorteile des erfindungsgemäßen Diagnoseverfahrens sind zu nennen.

Es kann bei beliebigen Ausgangsbedingungen, wie Umgebungstemperatur, Windgeschwindigkeit u.a.m. gearbeitet werden.

Der Widerstand einer Verbindung kann mit diesem Verfahren berührungslos ohne Unterbrechung des Energietransports bestimmt werden, und mit der Messung erfolgt eine Trendaussage zur weiteren Betriebsfähigkeit der untersuchten Verbindung.

Mit dem über das dynamische Wärmenetz ermittelten Wert des Verbindungswiderstandes $R_V$ sind wesentlich genauere Aussagen über die verbleibende Restnutzungsdauer $\Delta t_R$ möglich. Verbindungen sind mit dem neuen Diagnoseverfahren so zuverlässig diagnostizierbar, daß der Zeitpunkt einer notwendigen Energieunterbrechung (Abschaltung) in Folge eines wartungsbedingten Austauschs überalterter elektrotechnischer Betriebsmittel abgeleitet werden kann.

Weitere Einzelheiten, Merkmale und Vorteile der Erfindung ergeben sich aus der nachfolgenden Beschreibung eines Ausführungsbeispiels unter Bezugnahme auf die zugehörige Zeichnung. Es zeigen

Fig. 1  die schematische Darstellung des Meßverfahrens zur Bestimmung der Restnutzungsdauer einer elektrischen Verbindung,

Fig. 2  die Darstellung der Bestimmung des Verbindungswiderstandes $R_V$ aus gemessenem und berechnetem Temperaturverlauf,

Fig. 3  die Bestimmung der Restnutzungsdauer aus dem über das Alterungsmodell berechneten Lebensdauerverlauf.

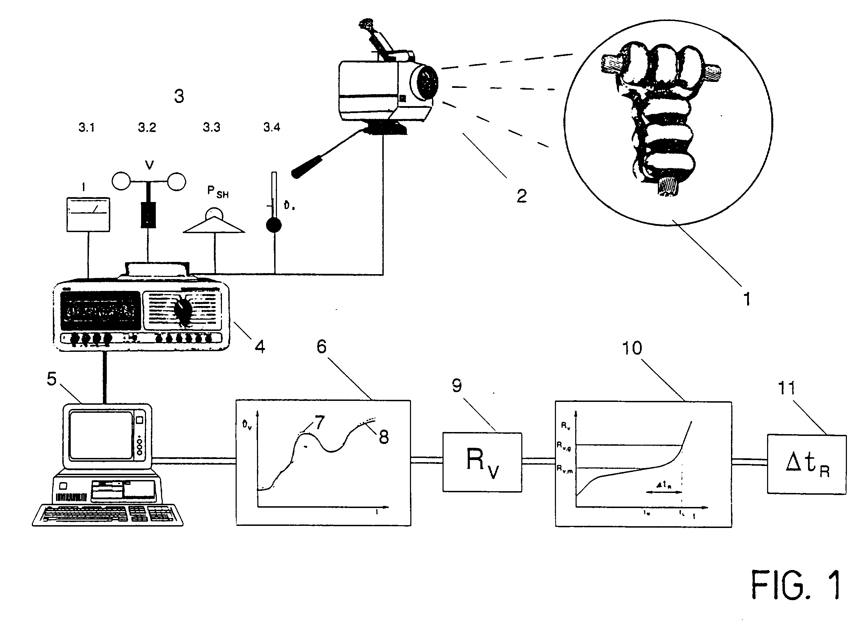

Fig. 1 veranschaulicht den prinzipiellen Ablauf des erfindungsgemäßen Meßverfahrens.

Der Widerstand einer T-Abzweigklemme 1 ist unter Betriebsbedingungen zu ermitteln. Ausgehend vom Verbindungswiderstand $R_V$ 9 ist abhängig von der zukünftigen Strombelastung die Restnutzungsdauer $\Delta t_R$ 11 der Verbindung zu ermitteln. Aus der Restnutzungsdauer 11 ist abzuleiten, wann die Erneuerung oder Ertüchtigung der Verbindung zu erfolgen hat. Dazu werden mit einer Infrarotkamera 2 über einen Zeitraum, der etwa 10 min. beträgt, der Temperaturverlauf und die Temperaturverteilung der Verbindung und der angeschlossenen drei Leiter 1 bis zu einem Abstand von jeweils der dreifachen Ortskonstante von der Verbindung 1 aufgezeichnet.

Gleichzeitig müssen auch alle die Temperatur der Verbindung 1 beeinflussenden Größen 3

- Belastungsstrom 3.1
- Windgeschwindigkeit und -richtung 3.2
- Leistung durch Sonnen- und Himmelsstrahlung 3.3
- Umgebungstemperatur 3.4

erfaßt und in einem Datenerfassungssystem 4 gespeichert werden.

Alle Daten, die durch die Infrarotkamera 2 und die Umgebungsparameter 3 aufzunehmen und zu speichern sind, werden zur weiteren Verarbeitung im Wärmenetzmodell dem dynamischen Wärmenetz 5 übergeben.

Mit diesem Programm erfolgt die Berechnung der Temperaturverteilung und des Temperaturverlaufs 6 für die Anordnung 1 abhängig von den durch 3.1 bis 3.4 erfaßten Daten.

Parallel zur Berechnung erfolgt auch ein Vergleich der mit der Infrarotkamera 2 gemessenen 7 und durch das Wärmenetzmodell berechneten Temperatur 8. Stimmen die beiden Temperaturverläufe 7 und 8 für die Verbindung 1 nicht überein, so wird der Verbindungswiderstand $R_V$ im Wärmenetzprogramm 5 solange verändert, bis beide Verläufe deckungsgleich sind. Der Widerstand, der zu dieser Übereinstimmung geführt hat, ist der gesuchte Verbindungswiderstand $R_V$ 9.

Ist der Widerstand $R_V$ 9 der Verbindung 1 zum Diagnosezeitpunkt $t_M$ bekannt, kann mit dem Lebensdauermodell 10, abhängig von der zu erwartenden Strombelastung, die Lebensdauer $t_L$ und die Restnutzungsdauer $\Delta t_R$ 11 berechnet und der Zeitpunkt einer Instandsetzung (Erneuerung) bestimmt werden.

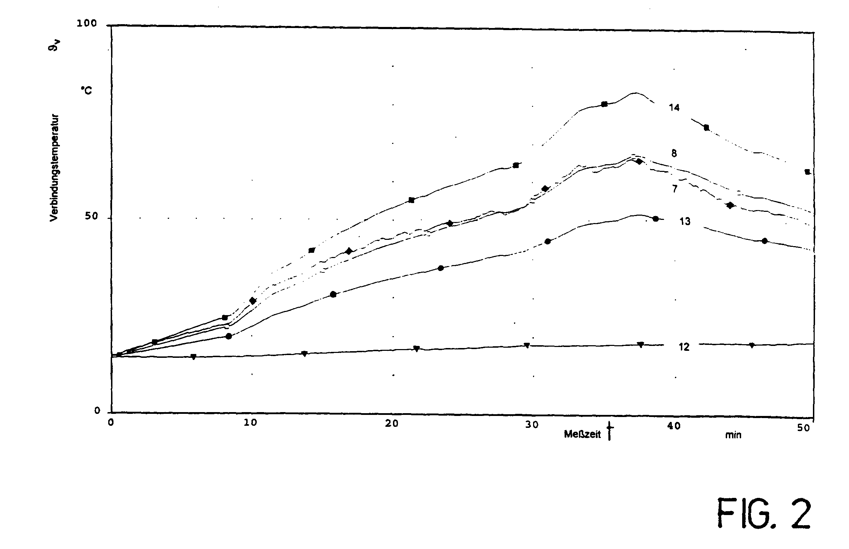

Die in Fig. 2 gezeigten Temperaturverläufe beziehen sich auf eine T-Abzweigklemme (Aluminium) mit Seil Al/St 240/40; die mit der Infrarotkamera 2 und einem Thermometer 3.4 gemessenen Temperaturverläufe der T-Abzweigklemme 7 und der Umgebung 12 werden über eine Zeit von hier 50 min mit berechneten Temperaturverläufen 8, 13 und 14 verglichen.

Durch Verändern des Verbindungswiderstandes $R_V$ im Wärmenetzprogramm 5 erfolgt der Angleich des berechneten Temperaturverlaufs 8 an den gemessenen Temperaturverlauf 7. Als Kriterium für den Angleich beider Verläufe wurde das Flächenintegral unter den Kurven herangezogen. Der Verbindungswiderstand gilt als bestimmt, wenn diese Integrale gleichgroß sind.

Es wird deutlich, daß durch Verändern von $R_V$ zu große 14 bzw. zu kleine Temperaturen 13 berechnet werden. Das Verfahren reagiert so empfindlich auf den gesuchten Widerstand der Verbindung 1, daß vor allem bei großen, gefährlichen Verbindungswiderständen Schwachstellen sehr sensibel erfaßt werden können.

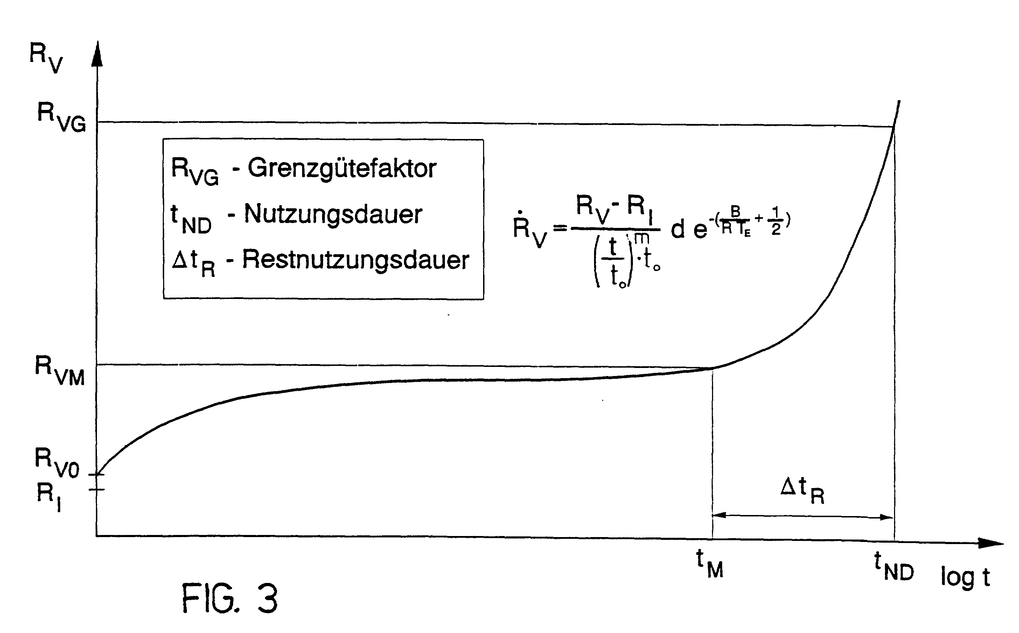

Ist der Verbindungswiderstand zum Zeitpunkt der Messung $t_M$ bekannt ($R_{VM}$), so kann mit dem Alterungsmodell gemäß Fig. 3 die Zeit berechnet werden, nach der ein Grenzwiderstand $R_{VG}$ für die Verbindung erreicht ist. Die Zeit, die zwischen dem Zeitpunkt der Messung $t_M$ und dem Erreichen des Grenzwiderstandes $R_{VG}$ liegt, wird als Restnutzungsdauer $\Delta t_R$ bezeichnet. Wie schnell der Grenzwiderstand $R_{VG}$ erreicht wird, hängt wesentlich von der zu erwartenden Strombelastung während der Zeit $\Delta t_R$ ab. Die Wirkung des Belastungsstromes wird in der Gleichung, die die Alterung beschreibt, über die Temperatur $T_E$ an den Engestellen des Kontaktes berücksichtigt. Der Grenzwiderstand $R_{VG}$ ist abhängig von den elektrischen Eigenschaften angrenzender Isolier- und Leiterwerkstoffe. Er wird aus Erfahrungen festgelegt oder über Grenztemperaturen berechnet.

## Patentansprüche

1. Verfahren zur Kontaktdiagnose an Elektroanlagen mit Hilfe der Infrarotmeßtechnik,
   **dadurch gekennzeichnet,** daß über eine bestimmte Zeit an der zu untersuchenden Kontaktverbindung (1) die Temperaturverteilung berührungslos (2) gemessen und aufgezeichnet wird und

   zeitgleich alle für die Temperaturverteilung wesentlichen dynamischen Einflußgrößen (3), wie Belastungsstrom (3.1), Windgeschwindigkeit und -richtung (3.2), Leistung der Sonnen- und Himmelsstrahlung (3.3) sowie Umgebungstemperatur (3.4) gemessen und ebenfalls aufgezeichnet (4) werden und
   die Werte der erfaßten Einflußgrößen als zeitabhängige Daten in ein die jeweilige untersuchte Kontaktverbindung adäquat beschreibendes Wärmenetz (5) eingegeben wird, woraus sowohl der Temperaturverlauf (6) als auch die Temperaturverteilung für die zu diagnostizierende Verbindung berechnet werden und durch Vergleich der gemessenen (7) und berechneten Temperaturen (8) unter Veränderung des zu diagnostizierenden Verbindungswiderstandes $R_V$ (9) die Temperaturverläufe angepaßt werden, wobei für den Fall, daß Verlauf und Verteilung übereinstimmen der gesuchte Widerstand $R_V$ (9) vorliegt.

2. Verfahren nach Anspruch 1,
   **dadurch gekennzeichnet,** daß das die zu diagnostizierende Verbindung am besten beschreibende Wärmenetz einer Wärmenetzbibliothek entnommen wird.

3. Verfahren nach einem der Ansprüche 1 oder 2,
   **dadurch gekennzeichnet,** daß die Dauer des Meßverfahrens pro zu untersuchender Kontaktverbindung (1) etwa 10 min beträgt.

## Claims

1. Process for contact diagnosis for electrical installations using infrared measuring techniques
   **characterized in** that the temperature distribution at the contact (1) to be examined is measured in a non-contacting manner (2) over a certain period of time and recorded, and

   at the same time all dynamic factors (3) essentially determining the temperature distribution, such as load current (3.1), velocity and direction of the wind (3.2), power of the sun and sky radiation (3.3) and the ambient temperature (3.4), are measured and also recorded (4), and
   the values of the factors monitored are input as time-independent data into a heat net (5) which adequately describes the contact actually tested wherefrom both the temperature course (6) and the temperature distribution are calculated for the contact to be diagnosed and the temperature courses are adapted by comparison of the measured temperatures (7) with the calculated temperatures (8) changing the contact resistance $R_v$ (9), whereby in case temperature course and distribution should agree the searched resistance $R_v$ is found.

2. Process to Claim 1
   **characterized in** that the heat net describing the contact to be diagnosed best, is taken from a heat net library.

3. Process to any of the Claims 1 or 2
   **characterized in** that the measuring time for each contact (1) to be examined is approximately 10 min.


**Revendications**

1. Une méthode pour le diagnostic de l'état d'un contact pour des installations électriques à l'aide d'une technique de lecture à infrarouge
   caractérisée par le fait que la répartition de la température du contact à examiner (1) est mesurée et enregistrée sans contact (2) pendant un certain laps de temps et

   que simultanément tous les facteurs dynamiques majeurs d'influence (3) sur la répartition de la température, tels que le courant de charge (3.1), la vitesse et la direction du vent (3.2), le débit des rayonnements solaires et atmosphériques (3.3) ainsi que la température environnante (3.4) sont mesurés et enregistrés également et que les valeurs ainsi acquises des facteurs d'influence en tant que données dépendantes d'un laps de temps sont inscrites dans un réseau de chaleur décrivant de manière adéquate le contact respectif examiné, et où le développement de température (6) aussi bien que la répartition de la température pour le contact à diagnostiquer sont mesurés et que, par la comparaison des températures mesurées et examinées (8), les développements de température sont ajustés sous transformation de la résistance du contact $R_v$ (9), dans le cas où, lorsque la variation et la répartion correspondent, la résistance $R_v$ (9) est disponible.

2. Une méthode selon la spécificité 1, est caractérisée par le fait que, le réseau de chaleur décrivant de la manière la plus adéquate le contact à diagnostiquer est extrait d'une bibliothèque de réseaux de chaleur

3. Une méthode selon les spécificités 1 ou 2 est caractérisée par le fait que la durée du processus de mesure par contact à examiner est d'à peu-près 10 minutes

FIG. 1

FIG. 2

$R_{VG}$ - Grenzgütefaktor

$t_{ND}$ - Nutzungsdauer

$\Delta t_R$ - Restnutzungsdauer

$$\dot{R}_V = \frac{R_V - R_I}{\left(\frac{t}{t_o}\right)^m \cdot t_o}\, d\, e^{-\left(\frac{B}{R\,T_E} + \frac{1}{2}\right)}$$

FIG. 3

EP 0 714 031 B1